# EUROPEAN PATENT APPLICATION

(11) **EP 4 697 877 A1**
(43) Date of publication of application: **18.02.2026**
(21) Application number: 24275093.3
(22) Date of filing: 14.08.2024
(51) Int. Cl.: H05K 7/20, F28F 13/00

(54) **HEAT TRANSFER DEVICE**

(71) Applicant: MBDA UK Limited, Stevenage, Hertfordshire SG1 2DA (GB)
(72) Inventor: The designation of the inventor has not yet been filed
(74) Representative: BAE SYSTEMS plc Group IP Department

(57) **Abstract**

A heat transfer device 100 with an enclosed cavity 110 partially filled with a conformable magnetic material 150. A first magnet 120 and a second magnet 130 are arranged to produce a magnetic field within the cavity. In a conductive mode, at least the first magnet is magnetised so as to attract the conformable magnetic material to form a thermal bridge across the cavity. In an insulating mode, the first magnet is de-magnetised and the second magnet is magnetised so as to attract the conformable magnetic material to form an insulating gap 110b across the cavity.

## Description

### FIELD

The present invention relates to a heat transfer device. More particularly, but not exclusively, it relates to a heat transfer device for use in missile systems, the device having a thermal conductivity that varies in dependence on the direction of heat transfer.

### BACKGROUND

There are many systems comprising complex electronic equipment that implement increasingly demanding functions and which must often operate over considerable amounts of time. As the complexity of the requirements for electronics rise, and the amount of time over which those electronics must be operated rises, the requirements for heat generated by those electronics to be appropriately managed become more significant. Many electronic components function optimally within a limited temperature range. Heat generated by their operation must be removed if these components are to remain within that limited temperature range over an extended period of time.

In some applications, it is possible to use an environmental heat dump in certain operating conditions, but not in others. For example, in missile systems, it is possible in some circumstances for an outer skin or airframe to provide a heat dump for this generated heat. However, the missile skin can heat significantly when the missile moves at very high speeds. As a result the missile airframe can also heat significantly. In these conditions the skin becomes a source of heat, rather than a possible heat sink, and it can be necessary to insulate the electronics from the skin and airframe so that the components do not overheat. There arises a need for a heat transfer device that is suitable for use in a missile application, and that can enable one or both of the missile skin and airframe to be used as a heat dump when possible, whilst insulating the internal electronic components from excess heat when the missile is subject to frictional heating due to high speed travel.

### SUMMARY

According to an aspect of the present invention, there is provided a heat transfer device comprising a body enclosing a cavity partially filled with a conformable magnetic material, and, a first magnet and a second magnet capable of producing a magnetic field within the cavity. In a conductive mode, at least the first magnet is magnetised so as to attract the conformable magnetic material to form a thermal bridge across the cavity. In an insulating mode, the first magnet is de-magnetised and the second magnet is magnetised so as to attract the conformable magnetic material such that an insulating gap is formed across the cavity. As such, the heat transfer device can actively/passively switch between modes, so that a component (to be cooled) can be cooled in the conductive mode, and protected from undesired heat in the insulating mode.

In one example, the first magnet is a first permanent magnet arranged in thermal contact with a point on the device between the cavity and a heat sink, and, the first permanent magnet is pre-selected such that it has a Curie temperature corresponding to a desired switching temperature at which the heat transfer device switches between the conductive mode and the insulating mode.

Preferably, when the temperature of the first permanent magnet is at, or above, its Curie temperature, the device is in the insulating mode. When a heat sink in contact with the first permanent magnet becomes too hot (i.e. higher temperature than the component being cooled), the heat transfer device passively switches to the insulating mode, thus protecting the device from overheating.

In one example, the second magnet is a second permanent magnet. Preferably, the second permanent magnet is arranged in thermal contact with a point on the device between the cavity and a heat source, and the second permanent magnet is pre-selected such that it has a Curie temperature which is higher than the Curie temperature of the first magnet. This permits the second permanent magnet to remain magnetised when the first magnet reaches its Curie temperature (and thus de-magnetise), such that the remaining magnetic field attracts the conformable magnetic material to form an insulating gap.

In another example, the first magnet is a first electromagnet configured to be selectively turned on in the conductive mode and selectively turned off in the insulating mode. As such, the heat transfer device can actively switch as per the desires of a user.

In one example, the second magnet is a second electromagnet configured to be either selectively turned on in both the conductive mode and the insulating mode or, selectively turned off in the conductive mode and selectively turned on in the insulating mode.

Preferably, the device comprises a temperature sensor arranged to detect the temperature of the device at a point. The device may comprise a controller configured to receive signals from the temperature sensor. The controller may be configured to switch the device from the conductive mode to the insulating mode in response to receiving a signal indicating the temperature is above a predetermined temperature. As such, the device is automated and programmable, permitting greater user choice.

In another example, the device comprises a first temperature sensor arranged to detect a first temperature of the device at a point between the cavity and a heat sink, and a second temperature sensor arranged to detect a second temperature of the device at a point between the cavity and a heat source. The device may comprise a controller configured to receive signals from the first and second temperature sensors. The controller may be configured to switch the device from the conductive mode to the insulating mode in response to receiving signals indicating the first temperature is above the second temperature.

In one example, the device further comprises at least one further magnet arranged together with the first and second magnets to produce a magnetic field within the cavity. Each of the at least one further magnets may be arranged to be magnetised in at least one of the conductive mode and the insulating mode.

In one example, the conformable magnetic material has a relatively high thermal conductivity, and, the remaining capacity of the cavity is filled with a fluid having a relatively low thermal conductivity. As such, the remaining capacity provides a significant conductive barrier to effectively form an insulating gap across the cavity.

In one example, the first magnet and the second magnet are arranged on opposing sides of the cavity.

In one example, the cavity is defined by walls, and, the walls have a relatively low thermal conductivity. This prevents heat flowing around the walls, increasing the effectiveness of the insulating mode.

In one example, the device is arranged to have the form of a washer for a mechanical fastening. This allows the device to act both in a mechanical and thermal capacity: holding a component to be cooled in place while providing cooling means.

The invention extends to a system comprising a heat transfer device as described above, a heat source and a heat sink arranged to transfer heat across the cavity.

According to a third embodiment of the invention, there is provided a missile comprising a skin, internal electronics, and a heat transfer device according to the first or second aspects of the present invention, wherein the heat transfer device is arranged to transfer heat from the internal electronics to the skin.

### BRIEF DESCRIPTION OF THE FIGURES

Embodiments of the invention will now be described by way of example only with reference to the figures, in which:
Figure 1a shows a schematic view of a heat transfer device according to the present invention in a conductive mode;
Figure 1b shows a schematic view of a heat transfer device according to the figure 1a in an insulating mode;
Figure 2a shows a schematic view of a heat transfer device according to the present invention with thermal regions on the same side, in a conductive mode;
Figure 2b shows a schematic view of a heat transfer device according to the figure 2a in an insulating mode;
Figure 3a shows a schematic view of a heat transfer device according to the present invention with thermal regions that are perpendicular to one another, in a conductive mode;
Figure 3b shows a schematic view of a heat transfer device according to figure 3a in an insulating mode;
Figure 4a shows a schematic view of a heat transfer device according to the present invention with a first permanent magnet in thermal contact with a heat sink;
Figure 4b shows a schematic view of a heat transfer device according to figure 4a with a first permanent magnet acting as a thermal path between a heat sink and the device;
Figure 4c shows a schematic view of a heat transfer device according to figure 4a with a second permanent magnet acting as a thermal path between a heat source and the device;
Figure 5 shows a schematic view of a heat transfer device according to the present invention with a first electromagnet and a second electromagnet;
Figure 6a shows a schematic view of a heat transfer device according to the present invention in a conductive mode;
Figure 6b shows a schematic view of a heat transfer device according to figure 6a in an insulating mode;
Figure 7a shows a perspective view of a heat transfer device according to the present invention forming part of a fastening washer; and,
Figure 7b shows a perspective view of a heat transfer device according to figure 7a.

### DETAILED DESCRIPTION

The present invention relates to a heat transfer device comprising a body enclosing a cavity partially filled with a conformable magnetic material, and a first and second magnet capable of producing a magnetic field within the cavity. The conformable magnetic material is able to provide a thermal bridge to transfer heat across the cavity when the magnetic field is present.

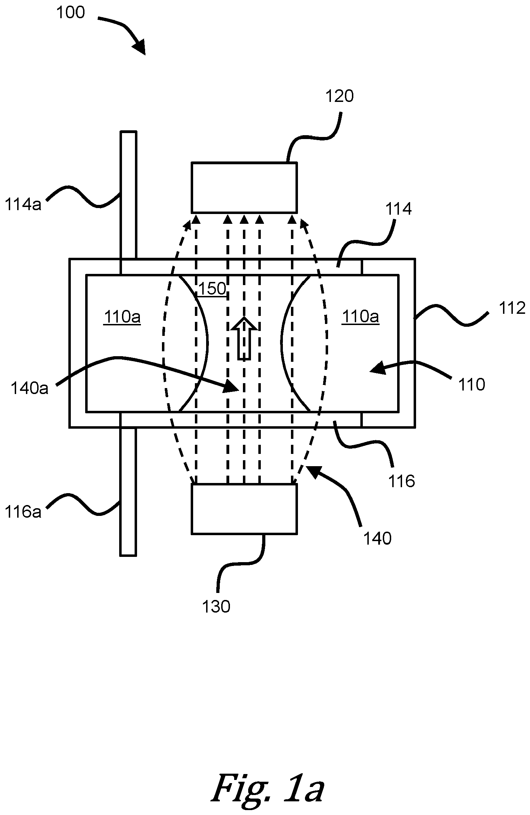

Figure 1a shows an example heat transfer device 100 comprising an enclosed cavity 110 partially filled with a conformable magnetic material 150. The cavity 110 is defined by a body 112. The body 112 comprises a plurality of walls that define the enclosed cavity 110. In the present example, there are four walls (top, bottom, left side and right side) shown, plus two walls not shown (front and back). The body 112 - and the body in all subsequent examples - may comprise any suitable shape or number of walls as desired.

The device 100 also comprises a first magnet 120 and a second magnet 130. The magnets 120, 130 are arranged to produce a magnetic field within the cavity.

In a conductive mode (as shown in figure 1a), the first magnet 120 and the second magnet 130 are each magnetised, and thus produce a region of relatively high magnetic flux density 140a extending between the magnets 120, 130 and through the cavity 110. The magnetic poles of each of magnets 120, 130 are aligned such that the magnetic field 140 extends across the cavity 110.

It will be appreciated by the skilled person that conformable magnetic material is any suitable material comprising magnetic material that experiences a force in a magnetic field and which is able to substantially conform its shape in response to the magnetic field. The magnetic field can be manipulated in such a way so as to attract conformable magnetic material as desired. The skilled person will appreciate that the conformable magnetic material does not necessarily have to conform precisely to the magnetic field lines in the present invention - rather, the magnetic field attracts the conformable magnetic material to conform to a desired shape such that a thermal bridge and an insulating gap are formed in respective conductive and insulating modes.

Preferably, the conformable magnetic material has a relatively high thermal conductivity. For example, the conformable magnetic material may be magnetic material in a powder/granular form. Alternatively, the conformable magnetic material may be magnetic material contained within a fluid, putty, slurry or the like. For example, the conformable magnetic material may be a ferrofluid or a magnetic liquid metal.

The powder/granular conformable magnetic material may comprise magnetic particles. The magnetic particles may comprise iron or a compound containing iron, such as magnetite or hematite. The magnetic particles may comprise graphite, a combination of graphite and iron, or a combination of graphite and compound containing iron. The magnetic particles may be nanoparticles, having dimensions around 1-100nm. The magnetic particles may be much larger, for example iron filings or the like (up to around 1 mm). The magnetic particles - whether nano-scaled or larger - have a relatively high thermal conductivity, such that the ferrofluid acts as an excellent thermal conductor.

It will be appreciated by the skilled person that a ferrofluid is a fluid comprising magnetic material that is attracted to a magnetic field. In particular, a ferrofluid is attracted to the poles of a magnet by virtue of the region immediately adjacent to the poles having relatively high magnetic flux density (compared to the rest of the magnetic field of said magnet). As such, a ferrofluid is able to change its shape/configuration in response to a magnetic. While a ferrofluid is also able to flow (so as to be able to change shape accordingly), once subjected to a magnetic field, it retains its shape until such a time as the magnetic field is removed or varied.

The ferrofluid may be a colloidal liquid comprising magnetic particles suspended in a carrier fluid. The magnetic particles may comprise iron or a compound containing iron, such as magnetite or hematite. The magnetic particles may comprise graphite, a combination of graphite and iron, or a combination of graphite and compound containing iron. The carrier fluid may comprise water, organic solvents, surfactants, oil, or some combination thereof. It will be appreciated by the skilled person that the ratio of carrier fluid to magnetic particles will depend on the desired thermal and/or magnetic characteristics of the ferrofluid.

The magnetic particles may be nanoparticles, having dimensions around 1-100nm. Alternatively, the ferrofluid may be a magnetic slurry: this is substantially the same as ferrofluid, but with larger magnetic particles. Such slurry magnetic particles may have dimensions greater than 100nm and up to around 1mm.

It will be appreciated by the skilled person that a magnetic liquid metal is a metal that is liquid at room temperature (or at the operating temperature of the device), and magnetic material suspended within the liquid metal. The magnetic material may be substantially the same as discussed above for a ferrofluid. The liquid metal may comprise gallium, indium, tin alloy, or any other suitable liquid metal or liquid metal alloy.

In the conductive mode, the conformable magnetic material 150 is attracted to the region of relatively high magnetic flux density 140a such that the conformable magnetic material 150 physically bridges across the cavity 110. Thus, the conformable magnetic material 150 forms a thermal bridge to transfer heat across the cavity 110 and, more generally, across the device 100. The remaining capacity of the cavity 110 is filled with a non-ferrous fluid 110a having a relatively low thermal conductivity, for example air.

It will be appreciated by the skilled person that "relatively" high and low thermal conductivity in this context refers the thermal conductivity of the conformable magnetic material relative to the non-ferrous fluid, insofar that the conformable magnetic material has a thermal conductivity that is relatively high when compared to the non-ferrous fluid. The specifics of each may be chosen/modified by the user of the present invention so as to provide the heat transfer characteristics (e.g. transfer rate in conducting and non-conducting modes) as desired for specific applications.

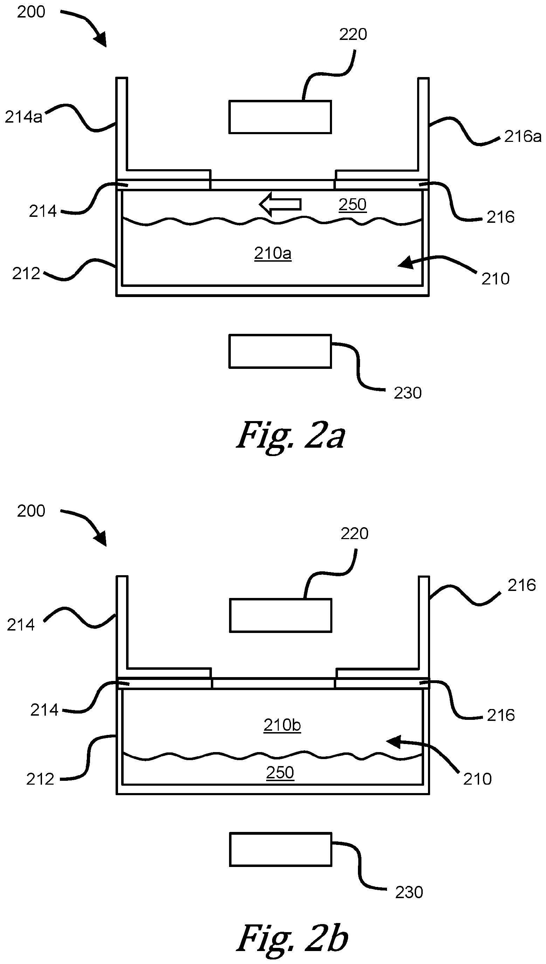

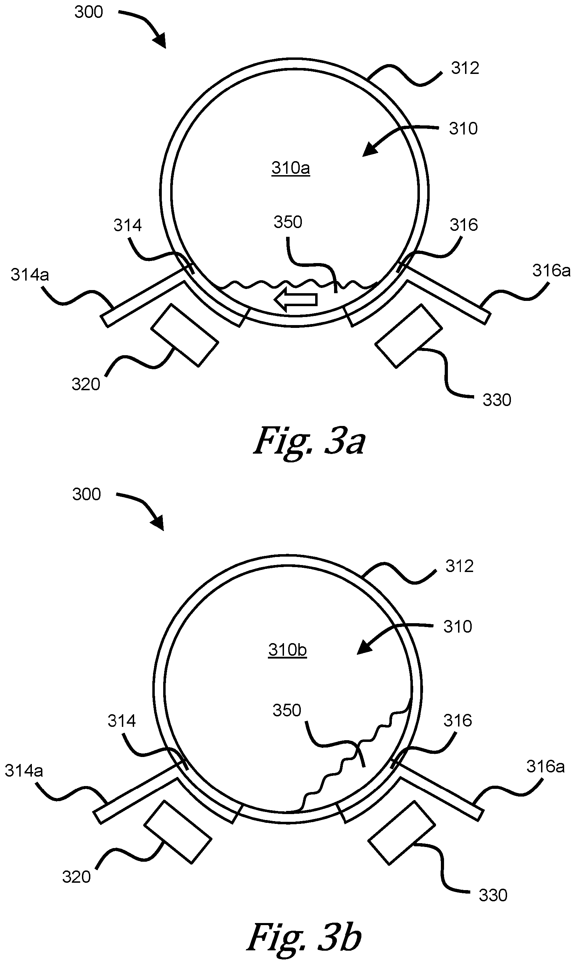

The device 100 also comprises a first thermal region 114 and a second thermal region 116 arranged on opposing walls of the body 112. Thermal regions are areas on the body 112 where heat transfer is desired during the conductive mode. These thermal regions may be on opposing walls of the body 112, i.e. so that heat transfer can occur from one side to another side (as shown in the present example). Alternatively, any orientation of these thermal regions are envisaged, for example different thermal regions on the same side of the body 112 (see figures 2a and 2b) or thermal regions that are perpendicular to one another about the cavity (see figures 3a and 3b). The skilled person will thus appreciate that the first and second magnets 120, 130 can be provided in a suitable arrangement to produce the overall magnetic field so as to attract the conformable magnetic material to form the thermal bridge across the cavity 110 in the conductive mode.

The thermal regions 114, 116 are integral to, or form a part of, the body's walls. In an example, where the thermal regions 114, 116form a part of the walls, both regions may comprise a relatively high thermally conductive material to permit heat transfer through the walls. Alternatively, where the thermal regions 114, 116 are integral to the walls, the walls may comprise a relative low thermally conductive material while the thermal regions 114, 116 comprise a relative high thermally conductive material. As such, in the conductive mode, the conformable magnetic material is attracted by the overall magnetic field 140a of the first and second magnets 120, 130 to physically bridge across the cavity between the first thermal region 114 and the second thermal region 116, thus providing a thermal bridge.

Each thermal region 114, 116 comprises a respective portion 114a, 116a to provide a thermal path to a heat sink and a heat source, or vice versa - these portions 114a, 116a are nominally shown as thermal paths, however any suitable shape, material, design and contact area with the thermal regions is envisaged. Indeed, the portions 114a and 116a in each example are optional and may respectively be a heat sink and a heat source (and vice versa) that are each directly in contact with the device.

During use, heat from a heat source flows, in turn, to the second thermal contact 116, the conformable magnetic material (which is bridging across), the first thermal contact 114 and finally a heat sink (see arrow indicating direction of heat flow). It will be understood by the skilled person that, in the context of the present invention, "across" means that the device 100 can favourably transfer heat from one thermal region to another thermal region in a desired manner.

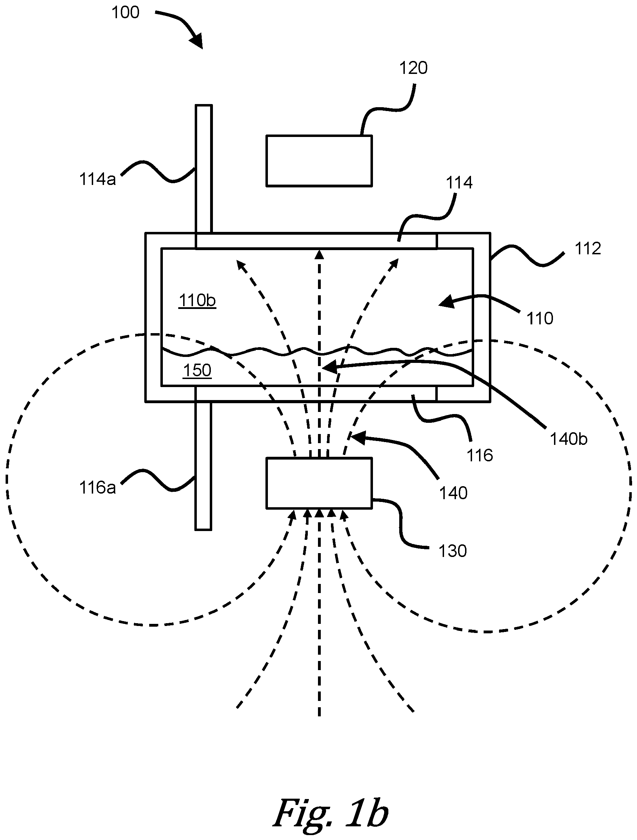

Figure 1b shows the example heat transfer device 100 in an insulating mode. The first magnet 120 is de-magnetised and the second magnet 130 is magnetised such that there is provided a region of relatively high magnetic flux density 140b extending into the cavity 110. The region of relatively high magnetic flux density 140b is proximate with the side of body 112 adjacent to the second magnet 130.

In the insulating mode, the conformable magnetic material 150 is attracted to the region of relatively high magnetic flux density 140b such that the conformable magnetic material 150 conforms to this region to form an insulating gap across the cavity 110. In other words, the thermal bridge is broken. The conformable magnetic material 150 forms an insulating gap 110b across the cavity 110 and, more generally, across the device 100.

As such, the device 100 can switch between the conductive mode and the insulating mode, permitting favourable heat transfer as desired by a user. As will be discussed below, switching between conductive and insulating modes may be passive or active.

The magnetic field can be manipulated in such a way so as to attract conformable magnetic material as desired. This is achieved by virtue of providing the first and second magnets 120, 130 in arrangements that best suit the heat transfer requirements of a user. The variables of such arrangements include, but are not limited to: the number of magnets; the type of magnets; the size of magnets; the strength of magnets; the orientation of magnets; and the combination of any of these variables. As such, the device 100 can be optimised to form a thermal bridge in the conductive mode and an insulating gap 110b in the insulating mode.

The first and second magnets 120, 130 may each comprise one or more magnets.

The walls may comprise low thermal conductivity non-metallic materials, such as ceramic, plastic (e.g. PEEK, polyimide) and composites. Alternatively, the walls may comprise low conductivity metallic materials, such as titanium. In one example, the thermal regions 114, 116 may comprise high thermal conductivity materials.

Figures 2a and 2b show an example heat transfer device 200 with a first thermal region 214 and a second thermal region 216 both on the same side. The device 200 comprises a cavity 210, a first magnet 220, a second magnet 230, conformable magnetic material 250, a body 212, a first thermal contact 214 and second thermal contact 216. The thermal contacts 214a, 216a are shown with a general "L" shape profile and are in thermal contact with the respective thermal regions 214, 216 on the side of the cavity 210 nearest to the first magnet 220, but at opposing ends.

In figure 2a, the heat transfer device 200 is in the conductive mode. The first magnet 220 is magnetised so as to attract the conformable magnetic material 250 to form a thermal bridge across the cavity 210. As such, heat can flow from the second thermal contact 216a to the first thermal contact 214a via, in turn, the first thermal region 214, the conformable magnetic material 250, and the second thermal region 216.

In the conductive mode, the second magnet 230 may be de-magnetised such that the first magnet 220 alone produces a region of relatively high magnetic flux density proximate to the side of body 212 adjacent to the first magnet 220. Alternatively, the second magnet 230 may be magnetised such that it produces a magnetic field of relatively low magnetic flux density compared to that of the first magnet 220. As such, the overall magnetic field produced by the magnets 220, 230 produces a region of relatively high magnetic flux density proximate to the side of body 212 adjacent to the first magnet 220.

In figure 2b, the heat transfer device 200 is in the insulating mode. The first magnet 220 is de-magnetised and the second magnet 230 is magnetised so as to attract the conformable magnetic material 250 to form an insulating gap 210b across the cavity 210. Heat can no longer flow from the second thermal contact 216a to the first thermal contact 214a via the conformable magnetic material 250.

Where the second magnet 230 was de-magnetised in the conductive mode (see discussion of figure 2a above), it has now been switched to be magnetised. Alternatively, where the second magnet 230 was magnetised in the conductive mode (and remains so), removal of the component of the magnetic field produced by the first magnet 220 now allows the second magnet 230 to dominate, and thus the conformable magnetic material 250 is attracted to the side of body 212 adjacent to the second magnet 230. In this second scenario, the second magnet 230 may either remain magnetised throughout, or it may be switched to produce a magnetic field with a magnetic flux density in the insulating mode that is higher than it produced in the conductive mode. For example, this may be achieved by increasing the current in an electromagnet (discussed in more detail below).

Figures 3a and 3b show an example heat transfer device 300 with thermal regions that are perpendicular to one another. The device 300 comprises a cavity 310, a first magnet 320, a second magnet 330, conformable magnetic material 350, a body 312, a first thermal region 314, a second thermal region 316, a first thermal contact 314a and second thermal contact 316a.

Figures 3a and 3b show the walls of the body 312 with a circular cross-section. The body 312 may comprises a cylinder or sphere. Alternatively, the walls of the body 312 may have any suitable cross-section, such as polygons or regular polygons. As such, the body 312 may comprise a prism, for example a rectangular prism, a cube, a triangular prism, etc. Any suitable shape and size of the body 312 defining the cavity 310 may be provided.

In figure 3a, the heat transfer device 300 is in the conductive mode. In figure 3b, the heat transfer device 300 is in the insulating mode.

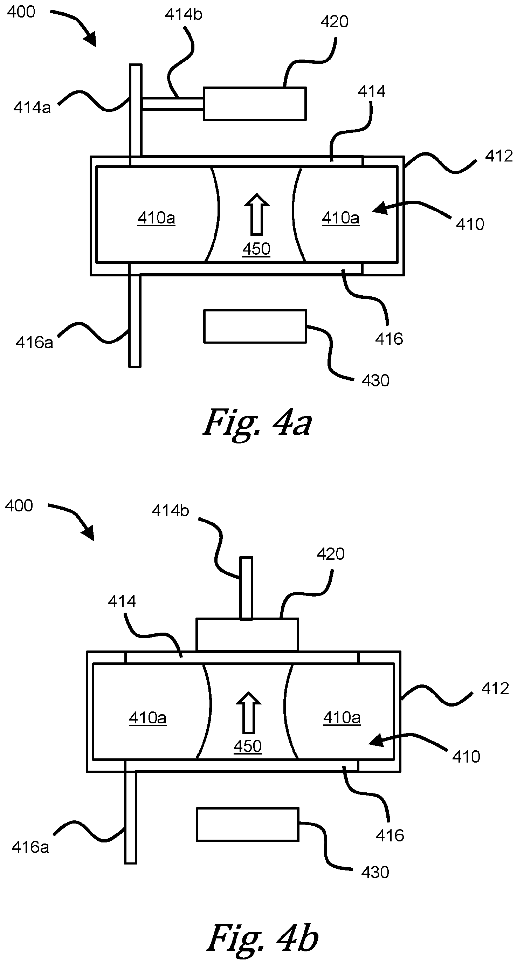

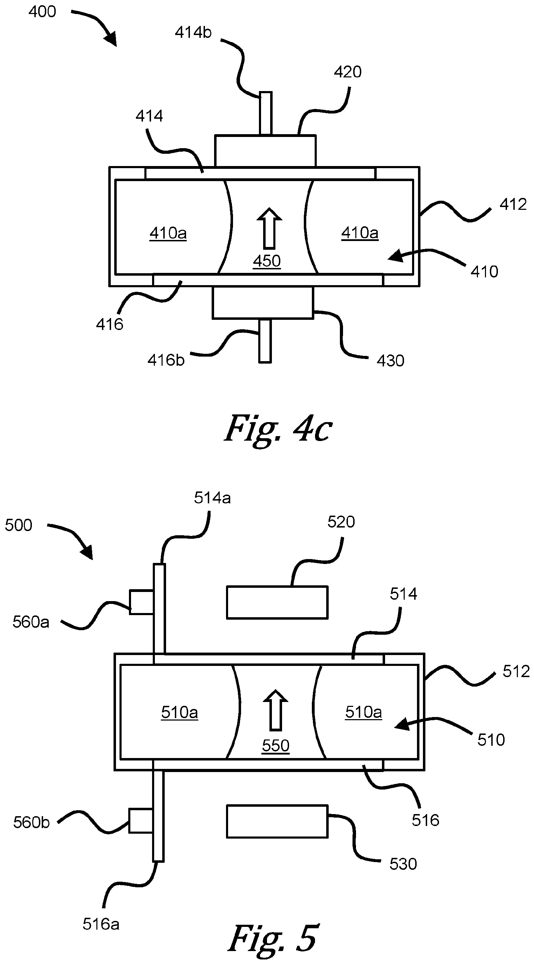

Figures 4a, 4b and 4c show an example heat transfer device 400 comprising a cavity 410, a first permanent magnet 420, a second magnet 430, conformable magnetic material 450, a body 412, a first thermal region 414, a second thermal region 416, a first thermal contact 414a and a second thermal contact 416a. The device 400 is shown in the conductive mode.

Figure 4a shows the device 400 with a thermal path 414b between the first thermal contact 414a and the first permanent magnet 420. The first permanent magnet 420 is pre-selected such that it has a Curie temperature corresponding to a desired switching temperature at which the heat transfer device 400 switches between the conductive mode and the insulating mode. The first permanent magnet is arranged in thermal contact with the first thermal contact 414a, in this example via the thermal path 414b.

By providing the first permanent magnet 420 in thermal contact with a point on the device 400 between the cavity 410 and a heat sink (not shown) during use, the first permanent magnet 420 is sensitive to the temperature experienced on the heat sink side of the device 400.

Consider the following example scenario: device 400 may be provided within the airframe of an air vehicle or missile so as to provide a thermal path between internal electronics and the skin of the airframe. As such, the device 400 can cool the internal electronics by virtue of the external environment (in thermal contact with the skin) often being at a temperature far below the operating temperature of the electronics. In one example, the internal electronics may operate at a temperature of around 20 to 85 C or more; the ambient environment temperature may be around -40 to 20 C.

For example, a missile may transition from lower speeds (e.g. subsonic, transonic or supersonic) during normal operation to higher speeds, such that aerodynamic heating dominates over the ambient environment temperature and begins to heat up the skin. Alternatively, a missile may be stored in an internal bay of an aircraft (subjected to ambient temperatures) and subsequently deployed. It is conceivable that skin can reach temperatures of around 80 to 150 C or more. Critically, should the temperature of the skin rise above that of the internal electronics: if the thermal path did not constitute the device 400 (and just a conventional thermal path, e.g. metal strip(s)), the flow of heat will reverse and the internal electronics will begin to uncontrollably heat up and potentially cease to function correctly.

However, the device 400 overcomes this limitation by being switchable between the conducting mode and the insulating mode. The first permanent magnet 420 is pre-selected such that it has a Curie temperature corresponding to a desired switching temperature - this may be 85 C in this example scenario. As such, the first permanent magnet 420 becomes de-magnetised at this temperature (and above) so that the heat cannot flow in the reverse direction. The thermal path 414b provides a route for the first permanent magnet 420 to experience the heat from the skin, such that the device is passively switchable between the conductive mode and the insulating mode.

Continuing with the scenario: the aircraft or missile may, after flying at high speeds (e.g. hypersonic), transition back to lower speeds. The skin temperature will subsequently decrease below that of the operating temperature of the internal electronics. Once the first permanent magnet 420 switches below its Curie temperature, it will once again be magnetised, such that device 400 is passively switched from the insulating mode to the conductive mode.

It will be appreciated by the skilled individual that any suitable permanent magnet and corresponding Curie temperature may be pre-selected to suit the specific requirements of the heat transfer device (for all examples disclosed herein). This may depend on the specific heat source that a user wishes to cool, the specific heat sink that will be used, and the ambient environment it will be exposed to.

Figure 4b shows the device 400 with the first permanent magnet 420 arranged between the first thermal region 414 and the thermal path 414b, which is thermal contact with a heat sink (not shown) during use. In other words, the first permanent magnet 420 acts as a thermal path between a heat sink and the cavity 410. Note that, in this arrangement, it is optional to include a first thermal contact 414a between the first permanent magnet 420 and the first thermal region 414 - this depends on the characteristics desired for thermal transfer between the cavity 410 and the first permanent magnet 420. In one example direct contact may be suitable. Alternatively, an intermediate heat transfer agent (i.e. a first thermal contact 414a) may be provided to optimise the heat transfer as desired.

Figure 4c shows the device 400 with the first permanent magnet 420 arranged between the first thermal region 414 and the thermal path 414b (as seen in figure 4b). Additionally, the second magnet 430 is a second permanent magnet 430 arranged between the second thermal region 416 and a second thermal path 416b, which is thermal contact with a heat source (not shown) during use.

The second permanent magnet 430 may be pre-selected such that it has a Curie temperature which is higher than the Curie temperature of the first permanent magnet 420. The Curie temperature of the second permanent magnet 430 may be selected such that it corresponds to a temperature above the operational temperature of a heat source. The second permanent magnet 430 will remain magnetised throughout the conductive and insulating modes of the device 400, which ensures that the conformable magnetic material 450 will form a thermal bridge 450 during the conductive mode and the conformable magnetic material 450 will form an insulating gap (110b; figure 1b) during the insulating mode.

While figure 4c shows the second permanent magnet 430 as part of the thermal path, it may be in thermal contact with any point on the device 400 between the cavity 410 and a heat source (not shown) during use. As such, the second permanent magnet 430 and second thermal path 416b may be a mirrored arrangement of the first permanent magnet 420 and the thermal path 414b as shown in figure 4a. Alternatively, the first thermal path 414b and/or second thermal path 416b may be omitted, such that the first permanent magnet 420 is in direct thermal contact with a heat sink and/or the second permanent magnet 430 is in direct thermal contact with a heat source.

Figure 5 shows an example heat transfer device 500 with a first electromagnet 520 and a second electromagnet 530. The device 500 also comprises a cavity 510, conformable magnetic material 550, a body 512, a first thermal region 514, a second thermal region 516, a first thermal contact 514a and a second thermal contact 516a. The device 500 is shown in the conductive mode.

The device 500 also comprises a first temperature sensor 560a and a second temperature sensor 560b. The first temperature sensor 560a is arranged to detect a first temperature of the device 500 at a point between the cavity 510 and a heat sink (not shown). The second temperature sensor 560b is arranged to detect a second temperature of the device 500 at a point between the cavity 510 and a heat source (not shown). Both temperature sensor 560a, 560b are shown in thermal contact with the first and second thermal contacts 514a, 516a respectively - they may be in contact with any other suitable point on the device 500.

The device 500 also comprises a controller (not shown) configured to receive signals from the first and second temperature sensors 560a, 560b, the signals indicating the first and second temperatures, respectively. The controller is also configured to selectively switch the device 500 from the conductive mode to the insulating mode in response to receiving signals indicating the first temperature is above the second temperature.

The first electromagnet 520 may be selectively turned on in the conductive mode and selectively turned off in the insulating mode. The second electromagnet 530 may be selectively turned on in both the conductive mode and the insulating mode. Alternatively, the second electromagnet 530 may be selectively turned off in the conductive mode and selectively turned on in the insulating mode (corresponding to the arrangement of figure 2).

Re-consider the example scenario discussed above: the device 500 may be provided within the airframe of an aircraft or missile so as to provide a thermal path between internal electronics and the skin of the airframe. In this instance, the controller can be pre-programmed detect when the first temperature is above the second temperature. Subsequently, the controller actively switches the device 500 from the conductive mode to the insulating mode (by de-magnetising/magnetising the electromagnets 520, 530 accordingly) so as to prevent heat flowing into the internal electronics from the skin.

When the controller detects that the second temperature is above the first temperature, it actively switches the device 500 from the insulating mode to the conductive mode (or maintains the conductive mode where it was already in it).

The electromagnets 520, 530, temperature sensors 560a, 560b and the controller of figure 5 may be applied to any other suitable arrangement according to the present invention. For example, it may be applied to figures 2 and 3. Note that, where the thermal regions 214, 216 (see figures 2a, 2b) are on the same side, the first and second temperature sensors would correspond to the first thermal region 214 and the second thermal region 216, respectively.

Referring again to figure 5, the device 500 may only have one temperature sensor, for example the first temperature sensor 560a (omitting the second temperature sensors 560b entirely). The second magnet 530 may be an electromagnet or a permanent magnet in this example.

Re-consider the example scenario discussed above: the device 500 may be provided within the airframe of an aircraft or missile so as to provide a thermal path between internal electronics and the skin of the airframe. In this instance, the controller can be pre-programmed detect when the first temperature is above a pre-determined temperature at which a user wishes to switch from the conductive mode to the insulating mode.

Subsequently, the controller actively switches the device 500 from the conductive mode to the insulating mode. This is achieved by de-magnetising the first electromagnet 520 and, depending on the type of second magnet, actively or passively magnetising the second magnet 530 accordingly. For example, where the second magnet 530 is a second permanent magnet 530, it will merely remain magnetised throughout (assuming it is chosen with a sufficiently high Curie temperature and/or it is not in thermal contact with a point on a heat sink side of the device 500). Alternatively, where the second magnet 530 is a second electromagnet magnet 530, the controller will either actively maintain the second electromagnet magnet 530 magnetised in both the conductive mode and the insulating mode, or selectively switch the second electromagnet magnet 530 from de-magnetised in the conductive mode to magnetised in the insulating mode.

In an alternative example, the first magnet 530 may be a first permanent magnet 530 and the second magnet may be a second electromagnet magnet 530. Indeed, any suitable combination of magnet types are envisaged by the inventors of the present invention.

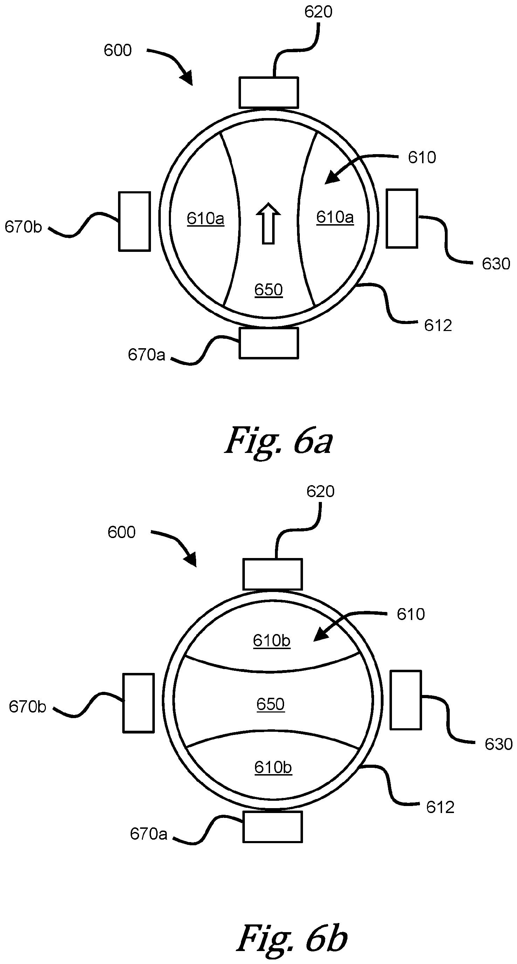

Figures 6a and 6b show an example heat transfer device 600 comprising a cavity 610, a body 612, conformable magnetic material 650, a first magnet 620 and a second magnet 630. The body 612 has a circular cross-section defining the cavity 610. Thermal contacts are omitted in this example - they may be optionally included depending on the magnets chosen and/or the heat transfer characteristics desired.

The device 600 also comprises a third further magnet 670a and a fourth further magnet 670b. The first magnet 620 and the second magnet 630 are arranged at points separated by 90 degrees about the body 612. The third further magnet 670a is arranged diametrically opposed to the first magnet 620. The fourth further magnet 670b is arranged diametrically opposed to the second magnet 630. The four magnet 620, 630, 670a, 670b are arranged around the body 612 substantially in quadrants.

While figures 6a, 6b do not show thermal regions, they are arranged on the walls substantially adjacent to the first magnet 620 and the further magnet 670b.

In figure 6a, the device 600 is in the conductive mode. The first magnet 620 at least is magnetised. As discussed above with respect to other examples, the other magnets 630, 670a, 670b may be magnetised or de-magnetised in any suitable manner so as to produce a region of relatively high magnetic flux density within the cavity 610 so as to attract the conformable magnetic material to form a thermal bridge across the cavity 610.

The first magnet 620 and the third further magnet 670a are magnetised to attract the conformable magnetic material to form a thermal bridge across the cavity 610, thus providing a thermal path. The second magnet 630 and the fourth further magnet 670b may be magnetised such that they produce a magnetic field of relatively low magnetic flux density compared to that of the first magnet 620 and the third further magnet 670a. Alternatively, the second magnet 630 and the fourth further magnet 670b may be entirely de-magnetised in the conductive mode.

In figure 6b, the device is in the insulating mode. The first magnet 620 is de-magnetised. As discussed above with respect to other examples, the other magnets 630, 670a, 670b may be magnetised or de-magnetised in any suitable manner so as to produce a region of relatively high magnetic flux density within the cavity 610 so as to attract the conformable magnetic material to form an insulating gap across the cavity 610.

The first magnet 620 and the third further magnet 670a are de-magnetised in the insulating mode. The second magnet 630 and the fourth further magnet 670b are magnetised in the insulating mode.

Any of the magnets 620, 630, 670a, 670b may be permanent magnets or electromagnets, and any combination thereof. Correspondingly, one or more temperature sensors (not shown) and a controller-according to discussed above - may be included where at least one of the magnets 620, 630, 670a, 670b is an electromagnet.

In one example, the first magnet 620 is a permanent magnets and the second magnet 630, the third further magnet 670a and the fourth further magnet 670b are each electromagnets. The first magnet 620 is pre-selected to have a Curie temperature corresponding to a desired switching temperature at which the device 600 switches between the conductive mode and the insulating mode.

Correspondingly, a controller is configured to receive a first temperature signal from a first temperature sensor. The first temperature sensor is arranged to detect a first temperature of the device 600 at a point between the cavity 610 and a heat sink (not shown) on the side of the first magnet 620. The controller is configured to magnetise the third further magnet 670a in the conductive mode and to de-magnetise the third further magnet 670a in the insulating mode. The controller is also configured to de-magnetise the second magnet 630 and the fourth further magnet 670b in the conductive mode and to de-magnetise the second magnet 630 and the fourth further magnet 670b in the insulating mode.

As such, the controlled is configured to switch the device 600 between the conductive mode and the insulating mode when it detects that the first temperature has reached (or is above) the Curie temperature of the first magnet 620. When the first magnet 620 is de-magnetised by virtue of reaching its Curie temperature, the controller simultaneously receives signals indicating the Curie temperature has been reached, and actively switches the device to the conductive mode.

Alternatively, the heat transfer 600 may only comprise the third further magnet 670a and not the fourth further magnet 670b. Alternatively, the heat transfer 600 may comprise any number of further magnets. Indeed, any combination of magnets and magnet types are envisaged.

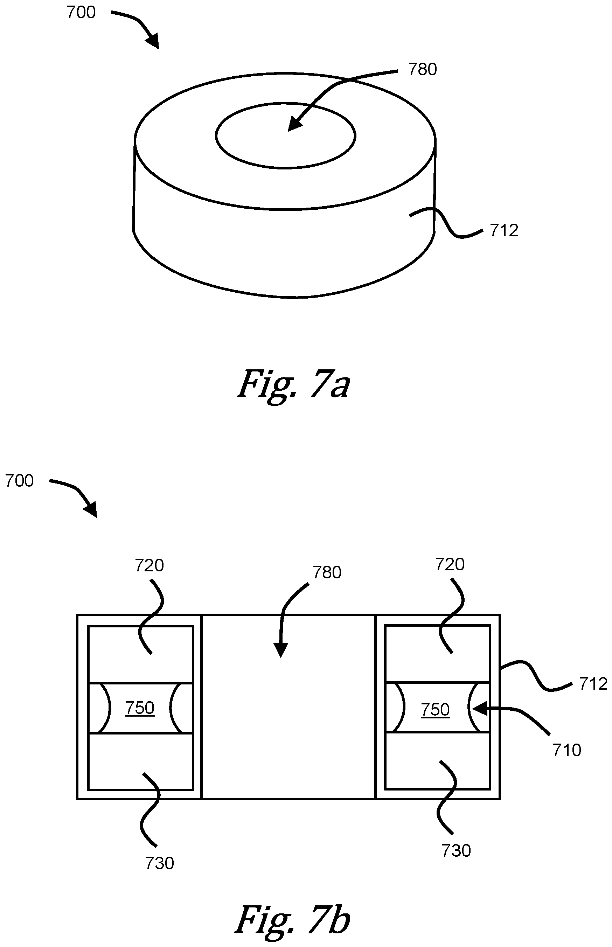

Figures 7a and 7b show an example heat transfer device 700 forming part of a fastening washer. The device 700 comprises an annular body 712 with an aperture 780 through the middle. The aperture 780 is for receiving a shaft of a bolt (or any other suitable fastening means). The washer may have a diameter of around 8-20mm, and more preferably around 13mm. The washer may have a thickness of around 5-15mm. The washer may have a hole with a diameter of around 4-6mm. The washer of the present invention may have suitable dimensions.

The annular body 712 also comprises an annular hollow arranged to hold a first annular magnet 720, a second annular magnet 730, and an enclosed cavity 710. The cavity 710 is enclosed by the inner and outer walls of the body 712 and the magnets 720, 730. In particular, the cavity 710 is sandwiched between the first magnet 720 and the second magnet 730. The cavity 710 is partially filled will a conformable magnetic material 750.

The body 712 may further comprise a first thermal region arranged between the first magnet 720 and the cavity 710, and a second thermal region arranged between the second magnet 730 and the cavity 710. Alternatively, the magnets 720, 730 may act both to define the cavity 710 and as a thermal interface with the conformable magnetic material 750, i.e. in place of thermal regions.

The first annular magnet 720 may be a first permanent magnet 720 and the second annular magnet 730 may be a second permanent magnet 730. The first permanent magnet 720 is pre-selected to have a Curie temperature corresponding to a desired switching temperature between the conductive mode and the insulating mode. As such, during use in the conductive mode, heat is arranged to flow from a heat source (not shown) in thermal contact with the bottom side of the device 700, through the second magnet 730, conformable magnetic material 750 and first magnet 720 in turn, and finally to a heat sink (not shown) in thermal contact with the top side of the device 700.

Preferably, the device 700 may be for a mechanical fastening, such as for fastening internal electronics of an aircraft or missile to the inside skin of the aircraft or missile's airframe. Thus, the device 700 not only provides a means for biasing the direction of heat transfer, but it also favourably permits a heat source (e.g. internal electronics) to be attached to a heat sink (e.g. airframe skin).

## Claims

1. A heat transfer device comprising:
a body enclosing a cavity partially filled with a conformable magnetic material; and,
a first magnet and a second magnet capable of producing a magnetic field within the cavity, and,
wherein:
in a conductive mode, at least the first magnet is magnetised so as to attract the conformable magnetic material to form a thermal bridge across the cavity; and,
in an insulating mode, the first magnet is de-magnetised and the second magnet is magnetised so as to attract the conformable magnetic material such that an insulating gap is formed across the cavity.

2. A device according to claim 1, wherein:
the first magnet is a first permanent magnet arranged in thermal contact with a point on the device between the cavity and a heat sink; and,
the first permanent magnet is pre-selected such that it has a Curie temperature corresponding to a desired switching temperature at which the heat transfer device switches between the conductive mode and the insulating mode.

3. A heat transfer device according to claim 2, wherein, when the temperature of the first permanent magnet is at, or above, its Curie temperature, the device is in the insulating mode.

4. A device according to claim any preceding claim, wherein the second magnet is a second permanent magnet.

5. A device according to claim 4, wherein:
the second permanent magnet is arranged in thermal contact with a point on the device between the cavity and a heat source; and,
the second permanent magnet is pre-selected such that it has a Curie temperature which is higher than the Curie temperature of the first magnet.

6. A device according to claim 1, wherein the first magnet is a first electromagnet configured to be selectively turned on in the conductive mode and selectively turned off in the insulating mode.

7. A device according to any of claims 1 to 3 or claim 6, wherein the second magnet is a second electromagnet configured to be either:
selectively turned on in both the conductive mode and the insulating mode; or,
selectively turned off in the conductive mode and selectively turned on in the insulating mode.

8. A device according to claim 6 or 7 further comprising:
a temperature sensor arranged to detect the temperature of the device at a point; and,
a controller configured to receive signals from the temperature sensor, and,
wherein the controller is configured to switch the device from the conductive mode to the insulating mode in response to receiving a signal indicating the temperature is above a predetermined temperature.

9. A device according to claim 6 or 7 further comprising:
a first temperature sensor arranged to detect a first temperature of the device at a point between the cavity and a heat sink;
a second temperature sensor arranged to detect a second temperature of the device at a point between the cavity and a heat source; and,
a controller configured to receive signals from the first and second temperature sensors, and,
wherein the controller is configured to switch the device from the conductive mode to the insulating mode in response to receiving signals indicating the first temperature is above the second temperature.

10. A device according to any preceding claim further comprising at least one further magnet arranged together with the first and second magnets to produce a magnetic field within the cavity, and,
wherein each of the at least one further magnets is arranged to be magnetised in at least one of the conductive mode and the insulating mode.

11. A heat transfer device according to any preceding claim, wherein the conformable magnetic material has a relatively high thermal conductivity, and,
wherein the remaining capacity of the cavity is filled with a fluid having a relatively low thermal conductivity.

12. A heat transfer device according to any preceding claim, wherein the first magnet and the second magnet are arranged on opposing sides of the cavity.

13. A heat transfer device according to any preceding claim, wherein the cavity is defined by walls, and,
wherein the walls have a relatively low thermal conductivity.

14. A heat transfer device according to any preceding claim, wherein the device is arranged to have the form of a washer for a mechanical fastening.

15. A system comprising:
a heat transfer device according to any preceding claim; and,
a heat source and a heat sink arranged to transfer heat across the cavity.
